# EUROPEAN PATENT APPLICATION

(11) **EP 1 517 596 A2**
(43) Date of publication of application: **23.03.2005**
(21) Application number: 04005268.0
(22) Date of filing: 05.03.2004
(51) Int. Cl.: H05K 1/16

(54) **High tollerance embedded capacitors**

(30) Priority: 18.09.2003 US 664638
(71) Applicant: E.I. du Pont de Nemours and Company, Wilmington, DE 19898 (US)
(72) Inventor: Fang, Xin, Newark Delaware 19711 (US); Borland, William J., Cary North Carolina 27513 (US)
(74) Representative: Hughes, Andrea Michelle

(57) **Abstract**

In a printed wiring board, capacitors (105) have electrode layers that may be selectively trimmed to obtain high tolerances. The electrode layers can be formed from a plurality of elongated electrode portions (114), each of which can be selectively trimmed. The electrode layers can also be formed from interdigitated elongated electrode portions.

## Description

### RELATED APPLICATIONS

This application is related to the application assigned attorney docket number EL-0495, United States Application Serial Number 60/418045, filed in the United States Patent and Trademark Office on October 11, 2002, and entitled "CO-FIRED CERAMIC CAPACITORS AND METHOD FOR FORMING CERAMIC CAPACITORS FOR USE IN PRINTED WIRING BOARDS," the application assigned attorney docket number EL-0496, United States Application Serial Number 60/433105, filed on December 13, 2002, and entitled "PRINTED WIRING BOARDS HAVING LOW INDUCTANCE EMBEDDED CAPACITORS AND METHODS OF MAKING SAME," and the application assigned attorney docket number EL-0497, United States Application Serial Number 60/453129, filed on March 7, 2003 and entitled "PRINTED WIRING BOARDS HAVING CAPACITORS AND METHODS OF MAKING THEREOF."

### BACKGROUND

### TECHNICAL FIELD

The technical field is capacitors. More particularly, the technical field includes high tolerance value capacitors that may be embedded in printed wiring boards.

### BACKGROUND ART

The practice of embedding passive circuit elements in printed wiring boards (PWB) allows for reduced circuit size and improved circuit performance. Passive circuit elements are typically embedded in panels that are stacked and connected by interconnection circuitry, with the stack of panels forming the printed wiring board. The panels can be generally referred to as "innerlayer panels."

Capacitors have varying requirements depending upon their intended uses. In many circuits, capacitor tolerance, which is the allowable variation around a target capacitance value, is critical. For example, in timing and analog-to-digital (A/D) conversion applications, capacitors generally have low capacitance values and high tolerances. Some of these capacitors have tolerance requirements of less than +/- 5% variation around their target value. In such cases, the high tolerance requirement is not easily obtained by common embedding techniques, such as screen printing or etching. Such capacitors may therefore be unsuitable for many applications requiring high tolerance.

The following US patent illustrates the state of the prior art.

U.S, 4,190,854 to Redfern, discloses a capacitor suitable for integration into a monolithic integrated circuit which is fabricated in two parallel connected sections. One section, using a thin oxide, constitutes most of the capacitance. A second section which is fabricated on a thick oxide constitutes a smaller capacitance per unit area but can be laser trimmed to provide a precise capacitance without damage to the integrated circuit. The trimmable section is desirably made using a conductive electrode material that is readily removed with laser energy.

### SUMMARY

According to a first embodiment, a printed wiring board is constructed from innerlayer panels. A capacitor in an innerlayer panel is made by forming a first electrode layer comprising a plurality of electrode portions, forming a dielectric contacting the first electrode layer, and forming a second electrode layer spaced from the first electrode layer, wherein the first electrode layer, the dielectric and the second electrode layer form a first capacitor. The capacitance of the capacitor may be set to have a capacitance that exceeds a desired or target capacitance value. One or more of the electrode portions of the first electrode layer are then trimmed or cut by a laser in order to disconnect a section of electrode from the capacitor so that the capacitance is lowered to a value that is close to or at the target value. The capacitor may be encased in organic dielectric material and incorporated into the printed wiring board along with additional innerlayer panels.

According to a second embodiment, a capacitor comprises a first electrode layer comprising a first plurality of elongated electrode portions, a second electrode layer comprising a second plurality of electrode portions spaced from and interdigitated with the first plurality of electrode portions, and a dielectric disposed between the first and second pluralities of electrode portions. One or more of the electrode portions may be trimmed in order to bring the capacitor to a target capacitance value.

Those skilled in the art will appreciate the above stated advantages and other advantages and benefits of various embodiments of the invention upon reading the following detailed description of the embodiments with reference to the below-listed drawings.

According to common practice, the various features of the drawings are not necessarily drawn to scale. Dimensions of various features may be expanded or reduced to more clearly illustrate the embodiments of the invention.

### BRIEF DESCRIPTION OF THE DRAWINGS

The detailed description will refer to the following drawings, wherein like numerals refer to like elements, and wherein:

### DETAILED DESCRIPTION

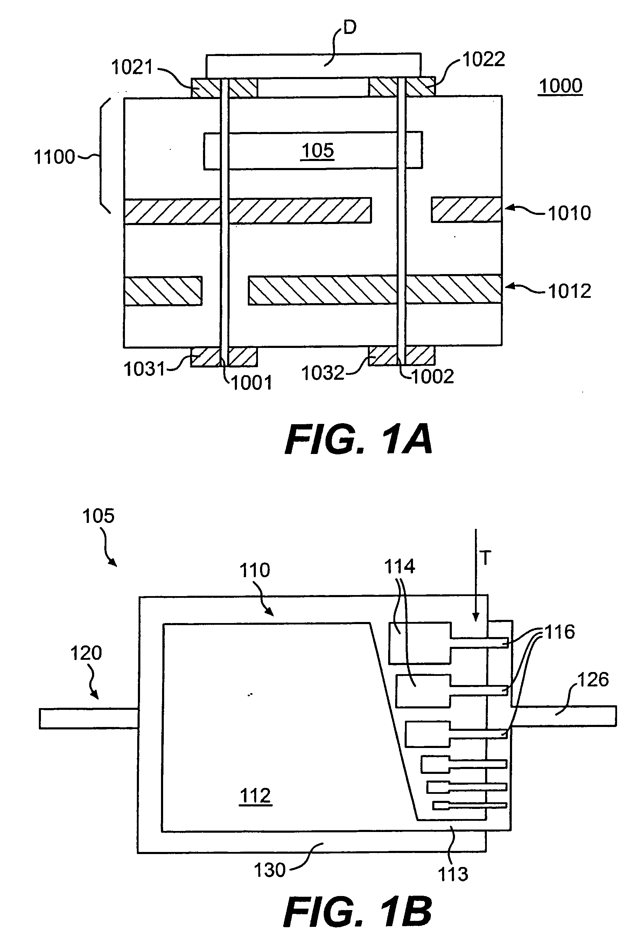

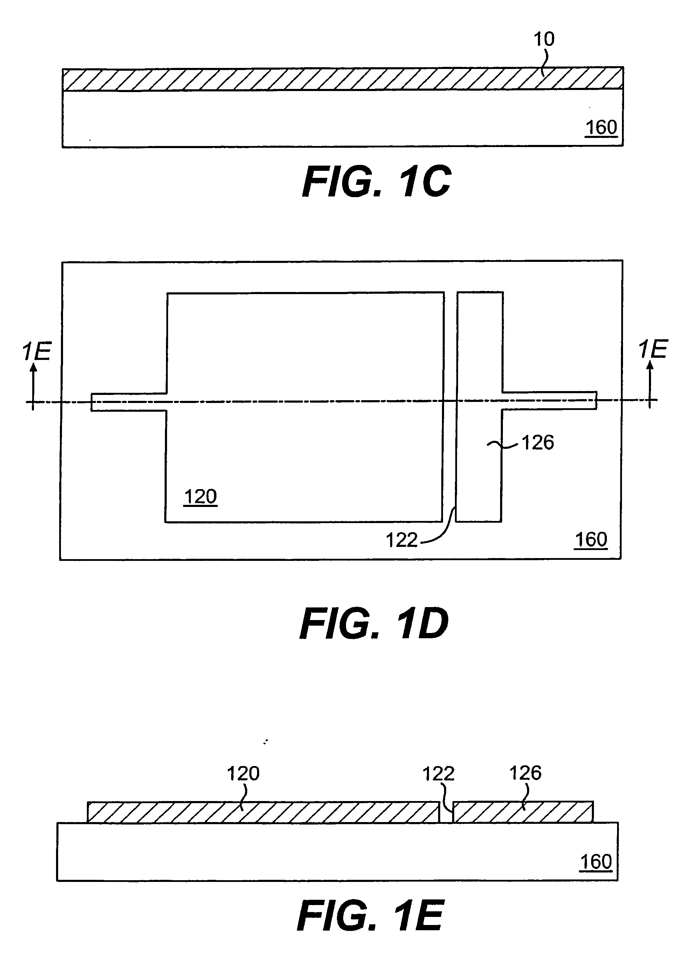

FIG. 1A is a schematic section view in front elevation of a printed wiring board 1000 according to a first embodiment of the invention. The printed wiring board 1000 comprises an innerlayer panel 1100 having an embedded capacitor 105. One innerlayer panel 1100 is illustrated in FIG. 1A. The printed wiring board 1000 can, however, comprise two or more innerlayer panels. According to the first embodiment, the capacitor 105 has trimmable electrodes.

Referring to FIG. 1A, the capacitor 105 is electrically coupled to two circuit conductors 1001, 1002 extending through the printed wiring board 1000. The completed innerlayer panel 1100, before incorporation in the printed wiring board 1000, is illustrated in FIG. 1I.

Referring to FIG. 1A, the printed wiring board 1000 includes connection circuitry 1021, 1022 and 1031, 1032 at opposite ends of the board 1000. The printed wiring board 1000 may also include a power plane 1010 and a ground plane 1012. The power plane 1010 may be formed as part of the innerlayer panel 1100. An exemplary device D is shown as coupled to the connection circuitry 1021, 1022. The device D can be, for example, a semiconductor chip.

FIG. 1B is a top plan view of the capacitor 105 schematically illustrated in FIG. 1A. The capacitor 105 includes a first electrode layer 110, a second electrode layer 120, and a dielectric 130. The first electrode layer 110 is separated from the second electrode layer 120 by the dielectric 130. Only a portion of the second electrode layer 120 is shown in FIG. 1B. The first electrode layer 110 may be electrically isolated from the second electrode layer 120 by a trench (not shown in FIG. 1B). The second electrode layer 120 can be formed from, for example, a metallic foil.

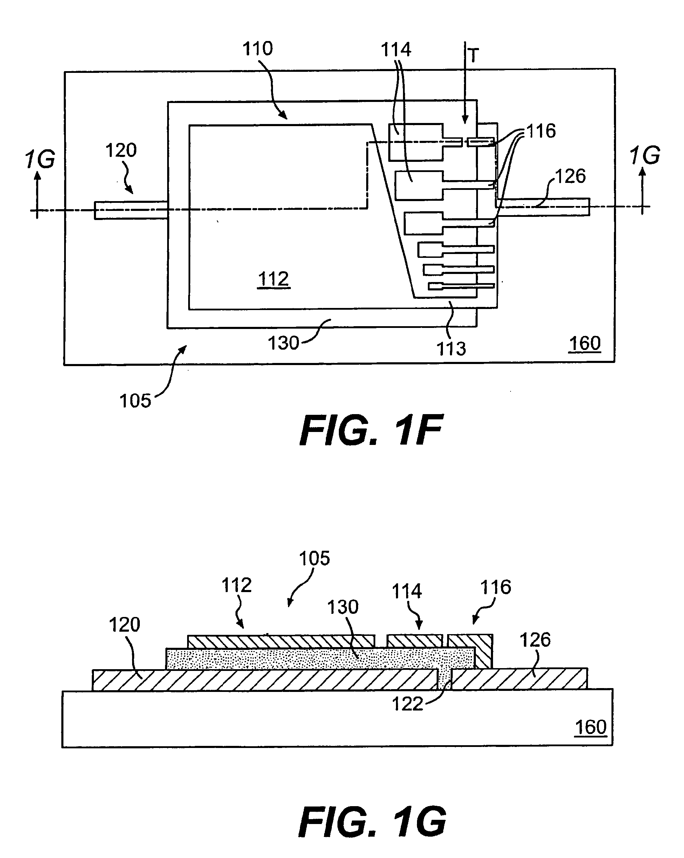

Referring to FIG. 1B, the first electrode layer 110 includes a plurality of electrode portions 114 of varying size, and a main electrode 112. The electrode portions 114 are connected to a conductive portion 126 by conductive portions 116. The main electrode 112 is electrically connected to the conductive portion 126 by a conductive portion 113. The first electrode layer 110 can be selectively trimmed across the conductive portions 116 in order to control the capacitance provided by the capacitor 105. A trim direction is indicated as the arrow *T* in FIG. 1B, and the trimming operation is discussed in detail below with reference to FIG. 1F. The main electrode 112 may be much larger than the electrode portions 114. Inclusion of the smaller trimmable electrode portions 114 allows for fine control of the total capacitance of the capacitor 105.

A method of making the innerlayer panel 1100 and a method of incorporating the innerlayer panel 1100 into the printed wiring board 1000 are discussed in detail below with reference to FIGS. 1C-1I. The completed innerlayer panel 1100, before incorporation into the printed wiring board 1000, is illustrated in FIG. 1I. The innerlayer panel embodiment discussed below is a polymeric capacitor embodiment. Other materials of construction, however, may be used to form the innerlayer panel 1100.

FIG. 1C is a section view in front elevation of a first stage of manufacture of the innerlayer panel 1100. In FIG. 1C, a metallic foil 10 is provided. The foil 10 may be of a type generally available in the industry. For example, the foil 10 may be copper, copper-invar-copper, invar, nickel, nickel-coated copper, or other metals. Preferred foils include foils comprised predominantly of copper, such as reverse-treated copper foils, double-treated copper foils, and other copper foils commonly used in the multilayer printed circuit board industry.

The thickness of the foil 10 may be in the range of, for example, about 1-100 microns, preferably 3-75 microns, and most preferably 12-36 microns, corresponding to between about 1/3 oz and 1 oz copper foil. The foil 10 is laminated to a first laminate material 160. The laminate material 160 may be, for example, FR4 prepreg and/or other organic materials.

FIG. 1D is a top plan view of the next stage of manufacture, and FIG. 1E is a section view taken on line 1E-1E in FIG. 1D. Referring to FIG. 1E, a photo-resist is applied to the foil 10 (reference number 10 is not used in FIGS. 1D and 1E), and the foil 10 is imaged, etched and stripped using, for example, standard printing wiring board processing conditions. Etching the foil 10 results in the second electrode layer 120 and the conductive portion 126 shown in FIG. 1D. A trench 122 isolates the second electrode layer 120 from the conductive portion 126.

FIG. 1F is a top plan view of a next stage of manufacture, and FIG. 1G is a section view taken on line 1G-1G in FIG. 1F. Referring to FIGS. 1F and 1G, the dielectric 130 is formed over the second electrode layer 120. The dielectric 130 fills the trench 122. The dielectric 130 may be formed from, for example, a polymer thick film (PTF) paste, and may be applied by, for example, solution casting or screen printing. The dielectric 130 is then cured. Solvents present in the dielectric 130 are removed during the curing process.

A first electrode layer 110 is then formed over the dielectric 130, forming the electrode portions 114, the main electrode 112 and the conductive portions 113, 116. The first electrode layer 110 may be formed from, for example, a conductive PTF paste. The first electrode layer 110 is then cured.

At this stage, the capacitance of the resulting article is higher than the capacitance that is ultimately desired for the finished capacitor. To reduce the capacitance value to the desired or "target" value, one or more of the electrode portions 114 may be selectively removed or disconnected from the capacitor by trimming (or "cutting") one or more of the conductive portions 116. In FIG. 1F, a trimming direction is indicated by an arrow T. A UV-YAG laser is one preferred device to perform trimming. The UV-YAG laser selectively cuts one or more conductive portions 116 to reduce the total area of the electrode layer 110, thereby reducing the capacitance of the capacitor 105. The electrode portions 114 can have successively smaller sizes to provide flexibility in adjusting the capacitance of the capacitor 105. The laser may be programmed with the electrode design and use a feedback process in which the laser initially measures total capacitance and calculates the number of electrode portions that are required to be trimmed in order to avoid either undershooting or overshooting the desired value. The laser may also measure the capacitance change throughout the trimming process and may be programmed to stop trimming within a certain range of the desired value. High tolerance values can be achieved by selective trimming of the electrode portions 114.

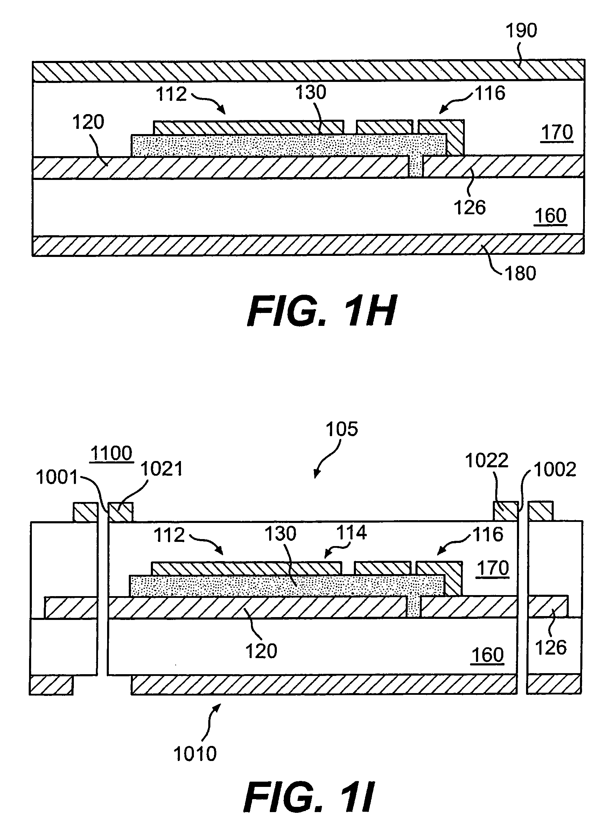

Referring to FIG. 1H, the resulting article is then laminated to a second laminate material 170. A foil 180 is applied to the first laminate material 160, and a foil 190 is applied to the second laminate material 170.

FIG. 1I illustrates the finished innerlayer panel 1100. Referring to FIGS. 1H and 1I, the foil 180 is imaged, etched and stripped to form an etched portion 1010. The etched portion 1010 can be, for example, a power plane. The foil 190 is also imaged, etched and stripped to form the connection circuitry 1021, 1022. After incorporating the innerlayer panel 1100 into the printed wiring board 1000, the circuit conductors 1001, 1002 can be formed through the printed wiring board 1000. A section of each of the circuit conductors 1001, 1002 is shown in FIG. 1I.

Referring back to FIG. 1A, the innerlayer panel 1100 can be stacked with other layers, including, for example, additional innerlayer panels. The printed wiring board 1000 can be formed from multiple stacked innerlayer panels by, for example, lamination processes. Stacked innerlayer panels can be laminated together in one or more conventional lamination pressings and bonded together using, for example, dielectric prepregs. The printed wiring board 1000 may be laminated in multiple stages. For example, subassemblies of innerlayer panels may be processed and laminated, and one or more subassemblies can subsequently be stacked and laminated together to form the finished printed wiring board 1000.

Each of the innerlayer panels in the printed wiring board 1000 can have a different design, including differing arrangements of circuit elements. The term "innerlayer panel" does not imply that a panel must be sandwiched in the interior of the printed wiring board 1000, and an innerlayer panel can also be located on, for example, outside layers of the printed wiring board 1000.

The first and second circuit conductors 1001, 1002 can be formed as conductive vias, for example, by laser or mechanical drilling through the printed wiring board 1100. The holes formed by drilling are then plated with a conductive material. The resulting conductive vias 1001, 1002, which extend through the entire printed wiring board 1000 shown in FIG. 1A, are typically referred to as "plated through-holes." Plated through-hole type vias are usually formed after all of the innerlayer panels of a printed wiring board have been laminated together. Additional circuit conductors (not shown) in other parts of the printed wiring board 1000 could extend through subassemblies of innerlayer panels or through individual innerlayer panels. Via circuit conductors extending through only a part of the printed wiring board 1000 are commonly referred to as "buried vias." Buried vias are typically drilled and plated through a subassembly of innerlayer panels before the subassembly of innerlayer panels is incorporated into a printed wiring board. A small diameter conductive via formed on one or both sides of an innerlayer panel is commonly referred to as a "microvia," and may be used, for example, to terminate a capacitor within an innerlayer panel. Any of the above-mentioned types of vias may be connected to the innerlayer panel embodiments discussed in this specification.

After all interconnections have been formed and all subassemblies of innerlayer panels or individual innerlayer panels have been laminated together, the printed wiring board 1000 is complete. In FIG. 1A, the printed wiring board 1000 is illustrated as comprising the innerlayer panel 1100, the ground plane 1012, the power plane 1010 and additional laminate layers in a stacked configuration. Any number of innerlayer panels may be included in a printed wiring board according to the embodiments discussed in this specification.

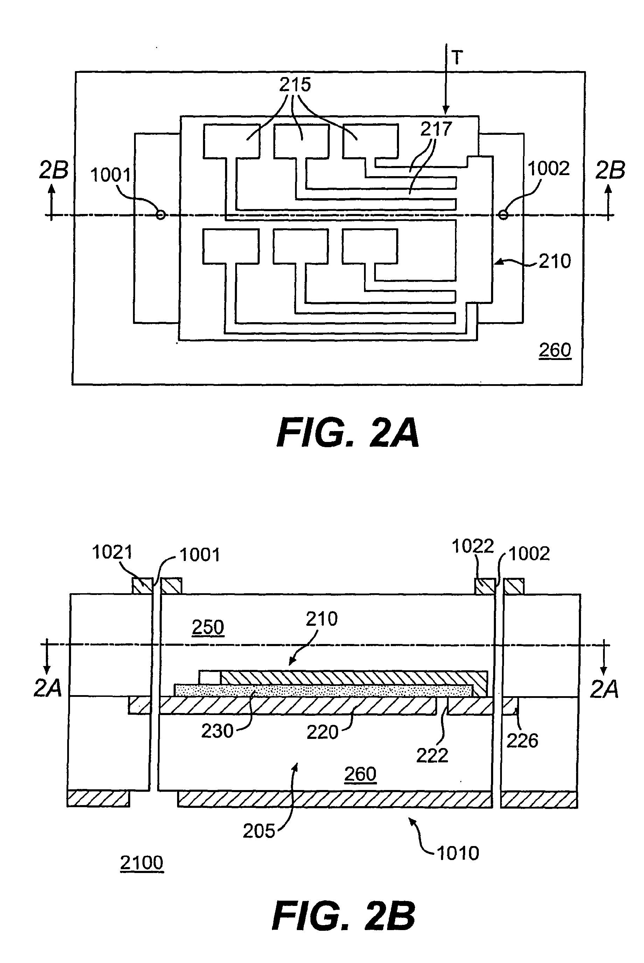

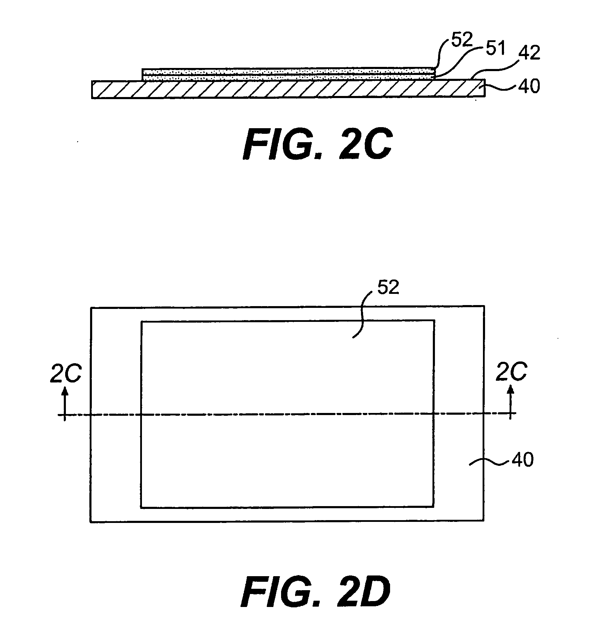

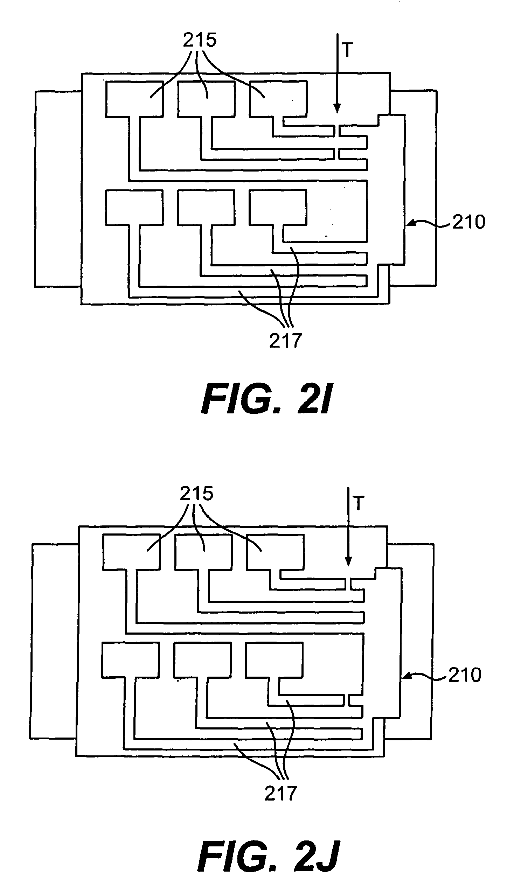

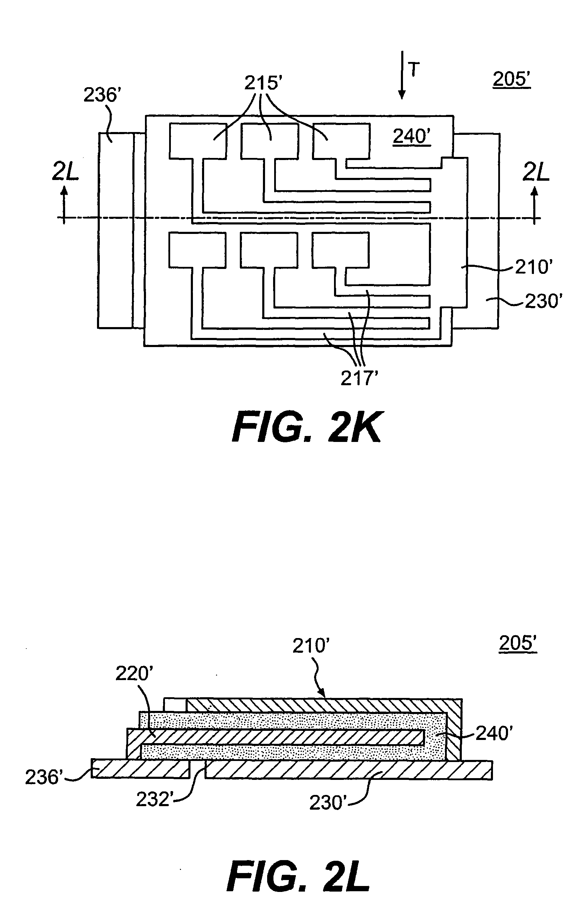

FIG. 2A is a top plan section view of a portion of an alternative innerlayer panel 2100, taken on line 2A-2A in FIG. 2B. FIG. 2B is a section view in front elevation, taken on line 2B-2B in FIG. 2A. The innerlayer panel 2100 can be incorporated into a printed wiring board such as, for example, the printed wiring board 1000 illustrated in FIG. 1A. FIG. 2B illustrates the innerlayer panel 2100 after its incorporation into the printed wiring board 1000. The innerlayer panel 2100 includes a capacitor 205 laminated between layers 250 and 260 of laminate material.

The capacitor 205 includes a first electrode layer 210 comprised of a plurality of electrode portions 215. The electrode portions 215 are interconnected by a plurality of conductive portions 217. A dielectric 230 separates the second electrode layer 220 from the first electrode layer 210. The first electrode layer 210, including the electrode portions 215 and the conductive portions 217, is electrically connected to a conductive portion 226. A trench 222 isolates the second electrode layer 220 from the first electrode layer 210.

The first electrode layer 210, including the plurality of conductors 215, is electrically coupled to the second circuit conductor 1002. The second electrode layer 220 is electrically coupled to the first circuit conductor 1001. In FIG. 2B, the circuit conductor sections 1001, 1002 correspond to a portion of the circuit conductors 1001, 1002 illustrated in FIG. 1A.

The capacitance of the capacitor 205 can be varied to within small variances by trimming one or more of the electrode portions 215. The trimming is performed on innerlayer panel 2100 by trimming through the laminate 250 and through the conductive portions 217. Circuit conductors 1021, 1022 may serve as probe points, for example, for testing the capacitance of the capacitor 205. The electrode portions 215 can be trimmed in a variety of combinations and locations, allowing for fine control of the capacitance provided by the capacitor 205. The process for making the innerlayer panel 2100, including the trimming process, is described below with reference to FIGS. 2C-2J.

The embodiment discussed below is a fired-on-foil embodiment using co-firing of capacitor layers. Other methods of construction, however, may be used to form the innerlayer panel 2100.

FIG. 2C is a section view in front elevation of a first stage of manufacturing the innerlayer panel 2100. In FIG. 2C, a metallic foil 40 is provided. The foil 40 may be of a type generally available in the industry. For example, the foil 40 may be copper, copper-invar-copper, invar, nickel, nickel-coated copper, or other metals that have melting points in excess of the firing temperature for thick-film pastes.

The foil 40 may be pretreated, for example, by applying and firing an underprint 42. The underprint 42 is a relatively thin layer applied to a component-side surface of the foil 40. In FIG. 2C, the underprint 42 is indicated as a surface coating on the foil 40. The underprint 42 adheres well to the metal foil 40 and to layers deposited over the underprint 42. The underprint 42 may be formed, for example, from a paste applied to the foil 40, which is then fired at a temperature below the melting point of the foil 40. The paste may be printed as an open coating over the entire surface of the foil 40, or printed on selected areas of the foil 40.

A dielectric material is screen-printed over the underprint 42, forming a first dielectric layer 51. The dielectric material may be, for example, a thick-film dielectric ink. The dielectric ink may be formed of, for example, a paste. The first dielectric layer 51 is then dried. A second dielectric layer 52 is then applied and dried. In an alternative embodiment, a single layer of dielectric material may be deposited through a mesh screen that is coarser than the mesh screen used to form the two separate layers 51, 52. The coarser mesh screen provides an equivalent thickness in one printing step.

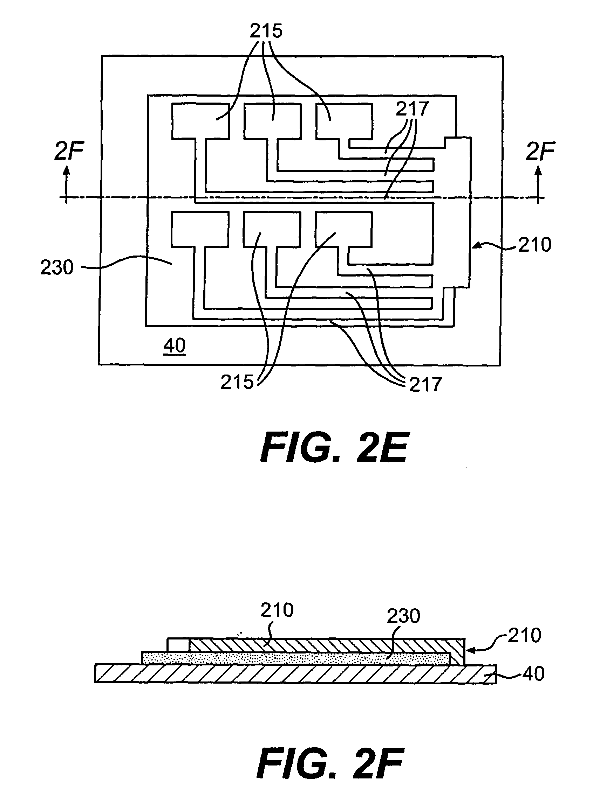

Referring to FIGS. 2E and 2F, a first electrode layer 210 is formed over the second dielectric layer 52 (reference numbers 51 and 52 are not used in FIGS. 2E and 2F) and dried. The first electrode layer 210 may be formed by, for example, screen-printing a thick-film metallic ink. The first electrode layer 210 is comprised of the plurality of electrode portions 215, which are interconnected by the plurality of conductive portions 217. A portion of the first electrode layer 210 extends over the dielectric layer 52 and contacts the foil 40. In general, the surface area of the dielectric layer 52, when viewed from a top plan perspective, should be larger than that of the first electrode layer 210.

The first dielectric layer 51, the second dielectric layer 52, and the first electrode layer 210 are then co-fired. "Co-fired" means that the layers 51, 52 are not fired prior to forming the first electrode layer 210. The post-fired structure is shown in FIGS. 2E and 2F. A dielectric 230 results from the co-firing step. The thick-film dielectric layers 51, 52 may be formed of, for example, a high K functional phase such as, for example, barium titanate and a dielectric property-modifying additive such as, for example, zirconium dioxide, mixed with a glass-ceramic frit phase. During co-firing, the glass-ceramic frit phase softens, wets the functional and additive phases and coalesces to create a dispersion of the functional phase and the modifying additive in a glass-ceramic matrix. At the same time, the first electrode layer 210 and the foil 40 are wetted by the softened glass-ceramic frit phase and sintered together. The first electrode layer 210 and the foil 40 have a strong bond to the high K dielectric 230 that results from the co-firing.

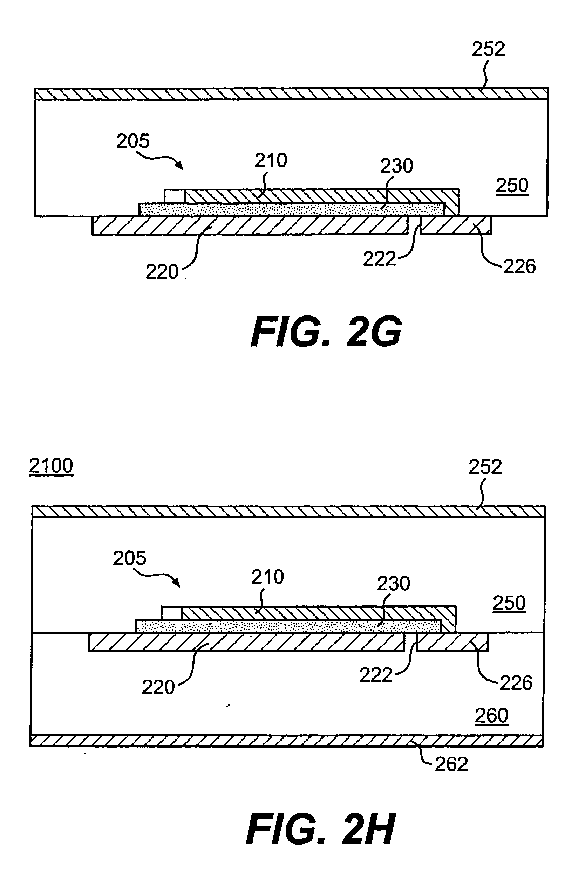

Referring to FIG. 2G, the structure is laminated on a first side of the foil 40 (reference number 40 is not used in FIG. 2G). For example, the component-side face of the foil 40 can be laminated to a laminate material 250 and to a conductive foil 252. The lamination can be performed, for example, using FR4 prepreg or other organic materials in standard printing wiring board processes.

After lamination, a photo-resist is applied to the foil 40 and the foil 40 is imaged, etched and stripped using, for example, standard printing wiring board processing conditions. The second electrode layer 220 results from the etching of the foil 40. The etching creates a trench 222 in the foil 40 which breaks electrical contact of the first electrode layer 210 from the second electrode layer 220. A portion 226 of the foil 40 is electrically connected to the first electrode layer 210. The electrode layers 210 and 220 and the dielectric 230 form the capacitor 205. The foil 252 may be etched at this time or at a later time. The foil 252 may be etched to form the circuitry 1021, 1022 illustrated in FIG. 2B.

Referring to FIG. 2H, the resulting article is laminated on a second side of the second electrode layer 220 to a second laminate material 260. A foil 262 may be applied to the second laminate material 260. The foil 262 may be etched to form circuitry. The foil 262 can be etched, for example, to form the power plane 1010 illustrated in FIG. 2B. Foil 252 may also be etched at this time.

According to this embodiment, the first electrode layer 210 may now be selectively trimmed in order to control the capacitance provided by the capacitor 205 (the capacitor 205 is shown in FIGS. 2A and 2B). Methods and patterns of trimming the first electrode layer 210 are discussed in detail below with reference to FIGS. 2I and 2J.

FIG. 2H illustrates the innerlayer panel 2100 before integration of the innerlayer panel 2100 into the printed wiring board 1000 illustrated in FIG. 1A, and before formation of the circuitry 1021, 1022, 1001, 1002 and the power plane 1010. FIGS. 2A and 2B illustrate the innerlayer panel 2100 after its incorporation into the printed wiring board 1000. The printed wiring board 1000 can be formed from multiple stacked innerlayer panels by, for example, lamination processes. The innerlayer panels can be laminated together in one or more lamination pressings. The innerlayer panels can be bonded together using, for example, dielectric prepregs and other organic materials, and may be laminated in multiple stages.

FIGS. 2I and 2J illustrate two exemplary trimming operations for the electrode 210. According to this embodiment, the electrode layer 210 may be selectively trimmed in order to control the capacitance provided by the capacitor 205 (FIGS. 2A and 2B). Trimming may be performed using, for example, a UV-YAG laser or a CO₂ laser or a combination of both.

FIGS. 2K and 2L illustrate an alternative embodiment to the capacitor 205 illustrated in FIGS. 2A and 2B. FIG. 2K is a top plan view of a capacitor 205', and FIG. 2L is a section view in front elevation taken on line 2L-2L in FIG. 2K. The capacitor 205' includes a first electrode layer 210', a second electrode layer 220', a third electrode layer 230', and a dielectric 240'. The first and third electrode layers 210', 230' are separated from the second electrode layer 220' by the two-layer dielectric 240'. The first and third electrode layers 210', 230' are electrically isolated from the second electrode layer 220' by a trench 232'. The third electrode layer 230' can be formed from, for example, a metallic foil.

Referring to FIG. 2K, the first electrode layer 210' includes a plurality of electrode portions 215' which are electrically coupled by conductive portions 217'. The first electrode layer 210' can be selectively trimmed in order to control the capacitance provided by the capacitor 205', as discussed above with reference to FIGS. 2I and 2J. The three-electrode, two-layer dielectric structure of the capacitor 205' provides a high capacitance.

The capacitor 205' can be formed in a manner similar to the capacitor 205 (FIGS. 2A and 2B), and can be similarly laminated and incorporated in a printed wiring board. When forming the capacitor 205', however, additional layers of dielectric are formed over the second electrode layer 220', and the first electrode layer 210' is formed over the additional dielectric layers. The capacitor 205' may be fired in one or in multiple firings. For example, the article can be fired after forming the second electrode layer 220', and fired again after forming the first electrode layer 210'. Alternatively, a single co-firing can be performed after forming the first electrode layer 210'. A single co-firing is advantageous in that production costs are reduced. Two separate firings, however, allow for inspection of the second electrode layer 220' for defects, such as printing alignment problems, after the first firing.

The first and third electrode layers 210', 230' may be electrically connected to a circuit conductor (not shown) contacting the third electrode layer 230'. The second electrode layer 220' can be electrically connected to a circuit conductor (not shown) contacting a conductive portion 236'. The circuit conductors connecting to the capacitor 205' can be similar to the circuit conductors 1001, 1002 illustrated in FIG. 1A. Other circuit conductor configurations are also possible.

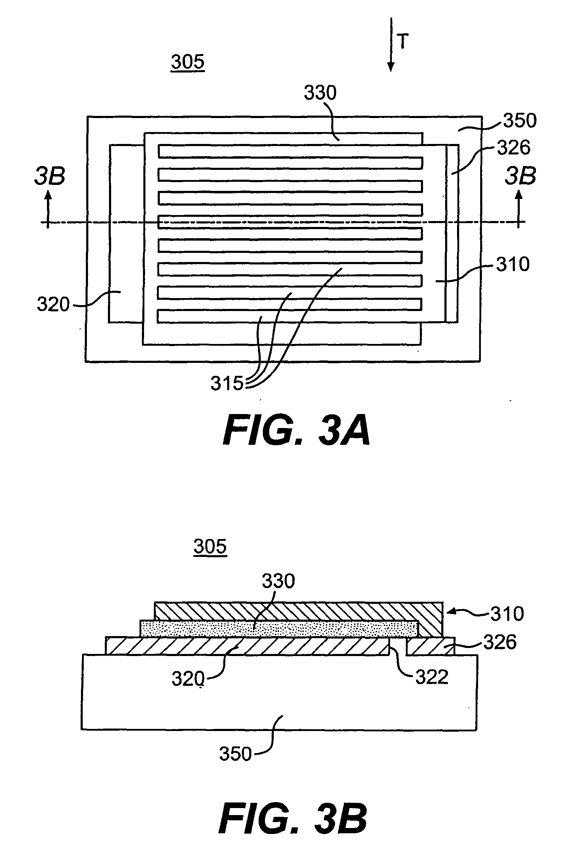

FIGS. 3A and 3B illustrate yet another alternative embodiment of a capacitor. FIG. 3A is a top plan view of a capacitor 305, and FIG. 3B is a section view in front elevation taken on line 3B-3B in FIG. 3A. The capacitor 305 includes a first electrode layer 310, a second electrode layer 320, and a dielectric 330. The capacitor 305 is formed over an organic laminate material 350. The first electrode layer 310 is separated from the second electrode layer 320 by the dielectric 330. The first electrode layer 310 may be electrically isolated from the second electrode layer 320 by a trench 322. The second electrode layer 320 can be formed from, for example, a metallic foil.

Referring to FIG. 3A, the first electrode layer 310 includes a plurality of elongated electrode portions 315. The electrode portions 315 can be selectively trimmed in order to control the capacitance provided by the capacitor 305, as discussed above with reference to FIGS. 1J and 1K.

The capacitor 305 can be formed in a manner similar to the capacitor 105 illustrated in FIG. 1B, using polymer thick film dielectric and conductor pastes. The capacitor 305 can be laminated and incorporated in a printed wiring board.

The first electrode layer 310 may be electrically connected to a circuit conductor (not shown) contacting a conductive portion 326. The second electrode layer 320 can be electrically connected to a circuit conductor (not shown) contacting the second electrode layer 320. The circuit conductors connecting to the capacitor 305 can be similar to the circuit conductors 1001, 1002 illustrated in FIG. 1A.

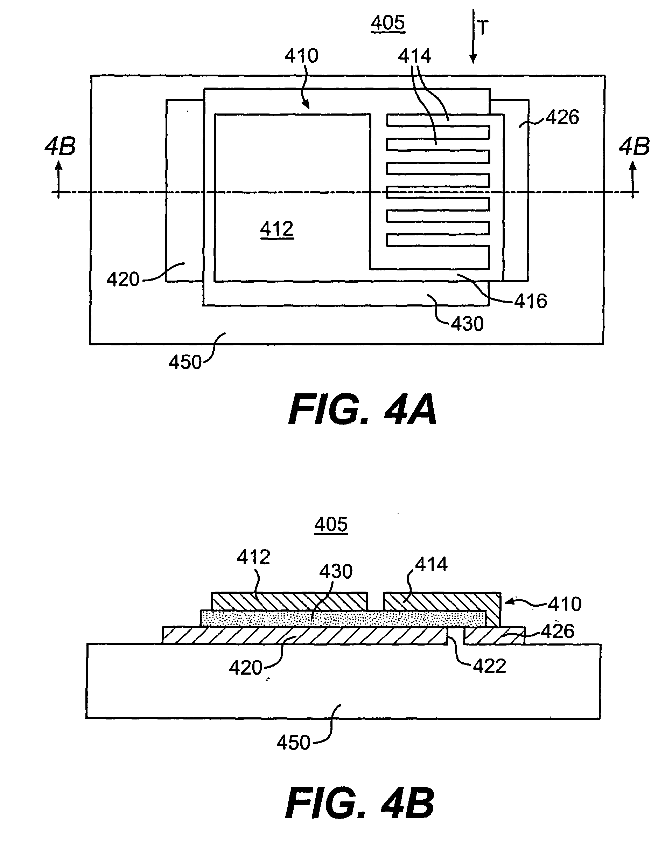

FIGS. 4A and 4B illustrate yet another alternative embodiment of a capacitor. FIG. 4A is a top plan view of a capacitor 405, and FIG. 4B is a section view in front elevation taken on line 4B-4B in FIG. 4A. The capacitor 405 includes a first electrode layer 410, a second electrode layer 420, and a dielectric 430. The capacitor 405 is formed over a laminate material 450. The first electrode layer 410 is separated from the second electrode layer 420 by the dielectric 430. The first electrode layer 410 may be electrically isolated from the second electrode layer 420 by a trench 422. The second electrode layer 420 can be formed from, for example, a metallic foil.

Referring to FIG. 4A, the first electrode layer 410 includes a plurality of electrode portions 414. The first electrode layer 410 can be selectively trimmed across the electrode portions 414 in order to control the capacitance provided by the capacitor 405. The first electrode layer 410 also includes a main electrode 412. Inclusion of the electrode portions 414 allows for fine control of the capacitance of the capacitor 405 because a relatively small portion of the first electrode layer 410 selectively trimmed.

The capacitor 405 can be formed in a manner similar to the capacitor 105 illustrated in FIG. 1B, using polymer thick film dielectric and conductor pastes. The capacitor 405 can be laminated and incorporated in a printed wiring board.

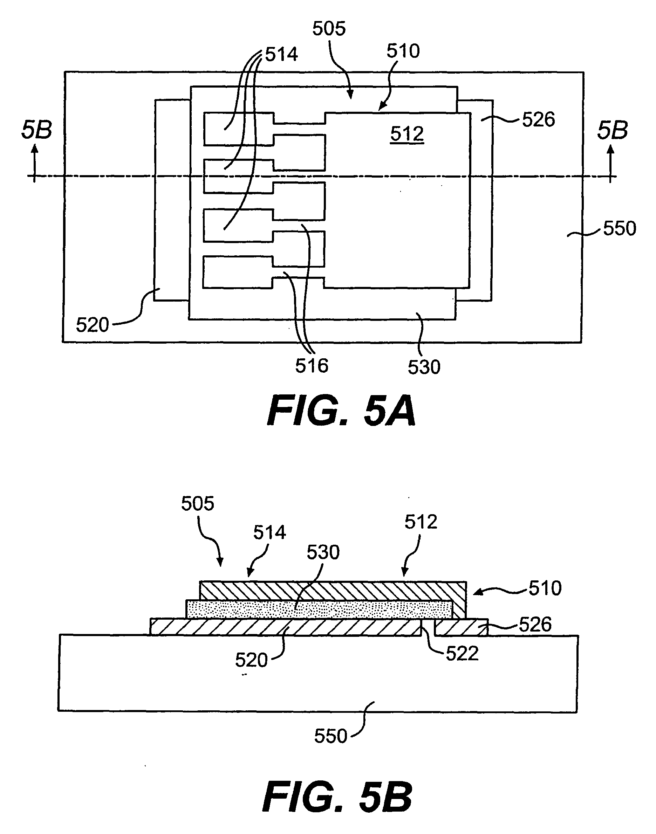

FIGS. 5A and 5B illustrate yet another alternative embodiment of a capacitor. FIG. 5A is a top plan view of a capacitor 505, and FIG. 5B is a section view in front elevation taken on line 5B-5B in FIG. 5A. The capacitor 505 includes a first electrode layer 510, a second electrode layer 520, and a dielectric 530. The capacitor 505 is formed over a laminate material 550. The first electrode layer 510 is separated from the second electrode layer 520 by the dielectric 530. The first electrode layer 510 may be electrically isolated from the second electrode layer 520 by a trench 522. The second electrode layer 520 can be formed from, for example, a metallic foil.

Referring to FIG. 5A, the first electrode layer 510 includes a plurality of electrode portions 514. The first electrode layer 510 can be selectively trimmed across conductive portions 516 in order to control the capacitance provided by the capacitor 505. The first electrode layer 510 also includes a main electrode 512 connected to the electrode portions 514 by the conductive portions 516. The main electrode 512 may be much larger than the electrode portions 514. Inclusion of the trimmable electrode portions 514 allows for fine control of the capacitance of the capacitor 505.

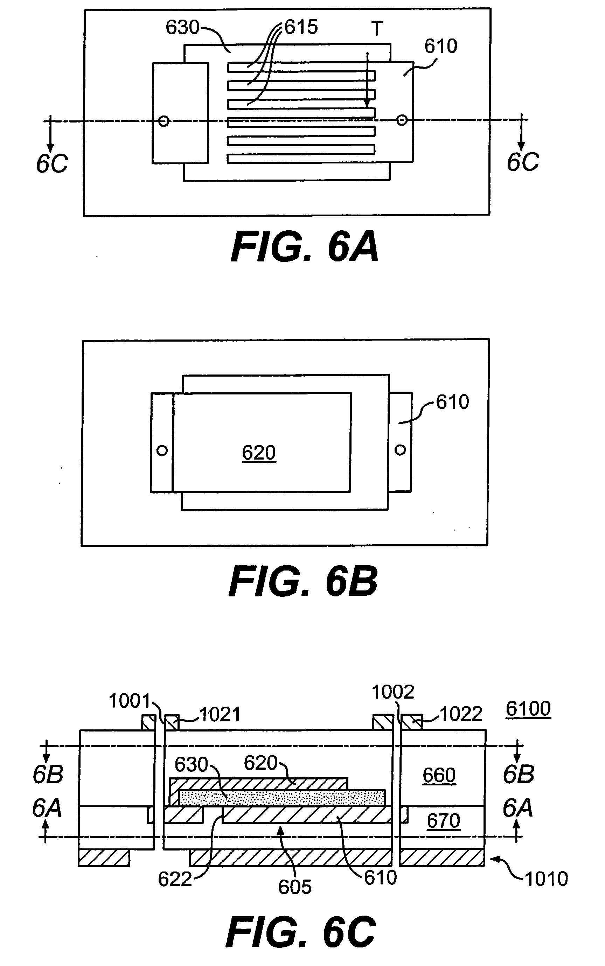

FIGS. 6A-6C illustrate yet another embodiment of a capacitor. In FIGS. 6A-6C, a capacitor 605 is embedded in an innerlayer panel 6100. FIG. 6A is a section view taken on line 6A-6A in FIG. 6C, and FIG. 6B is a section view taken on line 6B-6B in FIG. 6C. FIG. 6C is a section view taken on line 6C-6C in FIG. 6A

Referring to FIGS. 6A and 6C, the innerlayer panel 6100 comprises the capacitor 605 laminated to laminate materials 660, 670. The innerlayer panel 6100 is illustrated as it would appear after incorporation into a printed wiring board, such as the printed wiring board 1000 illustrated in FIG. 1A.

The capacitor 605 comprises a first electrode layer 610, a second electrode layer 620, and a dielectric 630. A trench 622 electrically isolates the first electrode layer 610 from the second electrode layer 620. Referring to FIG. 6A, the first electrode layer 610 comprises a plurality of elongated electrode portions 615. The capacitance value of the capacitor 605 is above the desired capacitance. The first electrode layer 610 can be selectively trimmed at the elongated electrode portions 615 in order to reduce the capacitance of the capacitor 605 to the desired value.

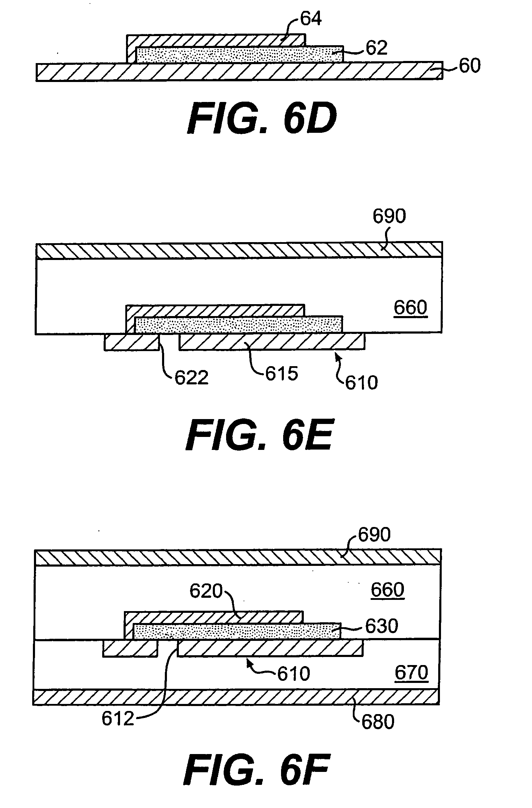

Referring to FIGS. 6A and 6C, an electrode portion 615 can be trimmed without damaging the second electrode layer 620. Specifically, when one or more electrode portions 615 are trimmed at the location indicated by the arrow T, if the trimming laser beam passes through the dielectric 630, the laser beam will not damage the second electrode layer 620 because the second electrode layer 620 does not extend over that part of the dielectric 630. A method of making the innerlayer panel 6100 is illustrated in FIGS. 6D-6F.

Referring to FIG. 6D, a foil 60 is provided, and a dielectric 62 is formed over the foil 60. The dielectric 62 can be formed in, for example, one or more screen-printing steps. Next, a conductive layer 64 is formed over the dielectric 62. The resulting article is co-fired.

Referring to FIG. 6E, the article is laminated to a laminate material 660, and a foil 690 is formed over the laminate material 660. The foil 60 (reference number 60 is not used in FIG. 6E) is then imaged, etched, and stripped. The etching operation results in the first electrode layer 610 having the elongated electrode portions 615. The elongated electrode portions 615 are then trimmed to obtain a desired capacitance.

Referring to FIG. 6F, the resulting article is laminated to a laminate material 670, and a foil 680 is formed over the laminate material 670. The foils 680, 690 may be used to form the circuitry 1021, 1022, 1010 illustrated in the finished innerlayer panel 6100 (FIG. 6C), or other circuitry may be formed. Conductive vias can be connected to the capacitor 605, such as the through-hole vias 1001, 1002 illustrated in FIG. 6C.

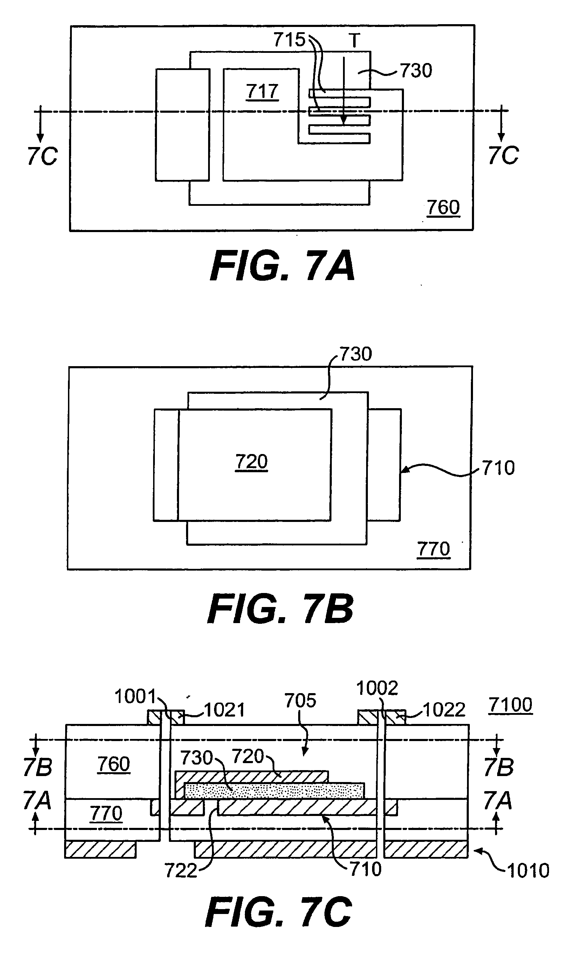

FIGS. 7A-7C illustrate yet another embodiment of an innerlayer panel 7100, similar to the innerlayer panel 6100 illustrated in FIGS. 6A-6C. The innerlayer panel 7100 comprises a capacitor 705 and laminate layers 770, 760, and is illustrated in a state after incorporation into a printed wiring board.

The capacitor 705 comprises a first electrode layer 710, a second electrode layer 720, and a dielectric 730. A trench 722 electrically isolates the first electrode layer 710 from the second electrode layer 720. Referring to FIG. 7A, the first electrode layer 710 comprises a plurality of elongated electrode portions 715, and a main electrode 717. The first electrode layer 710 can be selectively trimmed at the elongated electrode portions 715 in order to control the capacitance provided by the capacitor 705.

Referring to FIGS. 7A and 7C, an electrode portion 715 can be trimmed without damaging the second electrode layer 720. When one or more electrode portions 715 are trimmed at the location indicated by the arrow T, if the trimming laser beam passes thought the dielectric 730 the laser beam will not damage the second electrode layer 720 because the second electrode layer 720 does not extend over that part of the dielectric 730. The capacitor innerlayer panel 7100 can be formed in a manner similar to the capacitor 6100.

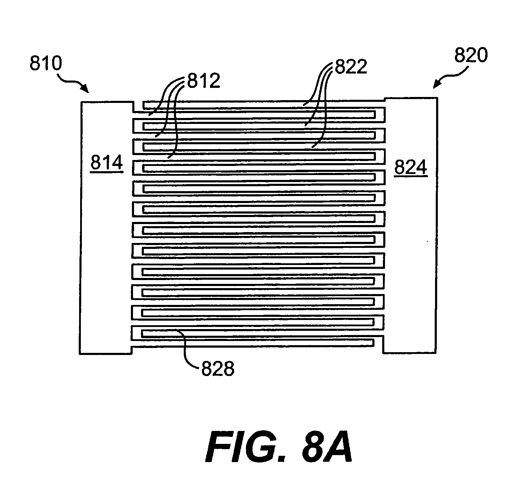

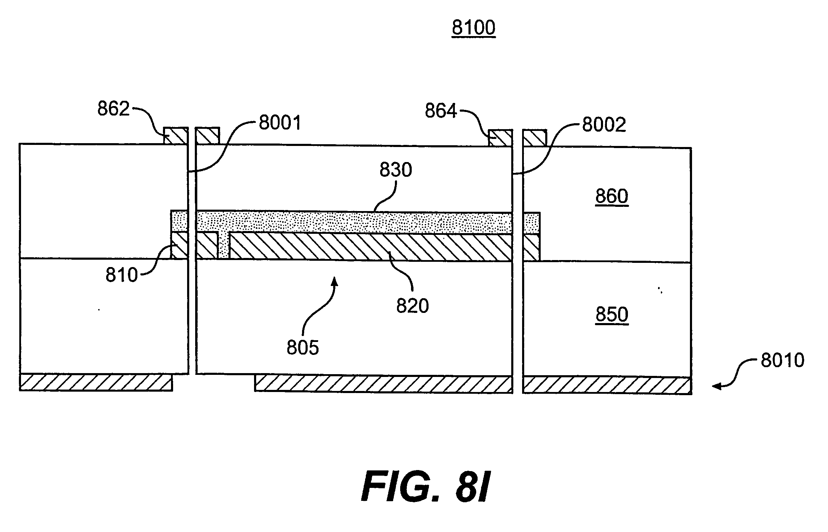

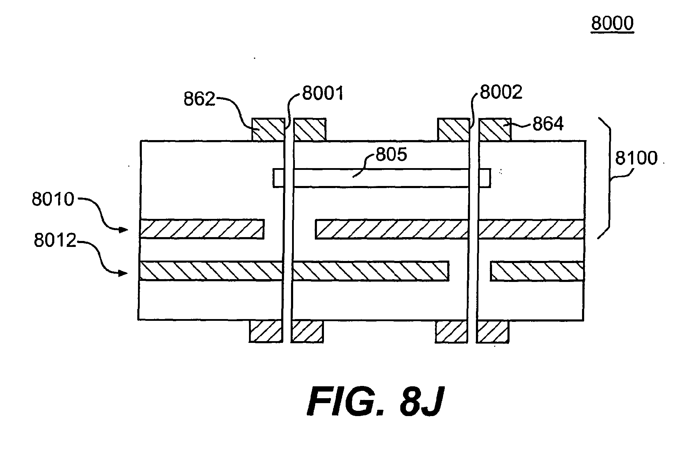

FIG. 8A is a top plan view of an electrode arrangement comprising interdigitated electrodes 810, 812. The electrodes 810, 812 are shown in isolation in FIG. 8A. A complete innerlayer panel 8100, including a capacitor 805 comprising the electrodes 810, 812, is illustrated in FIG. 81. A printed wiring board 8000 having the innerlayer panel 8100 incorporated therein is illustrated in FIG. 8J. The interdigitated electrode capacitor 805 is trimmable in order to adjust its capacitance.

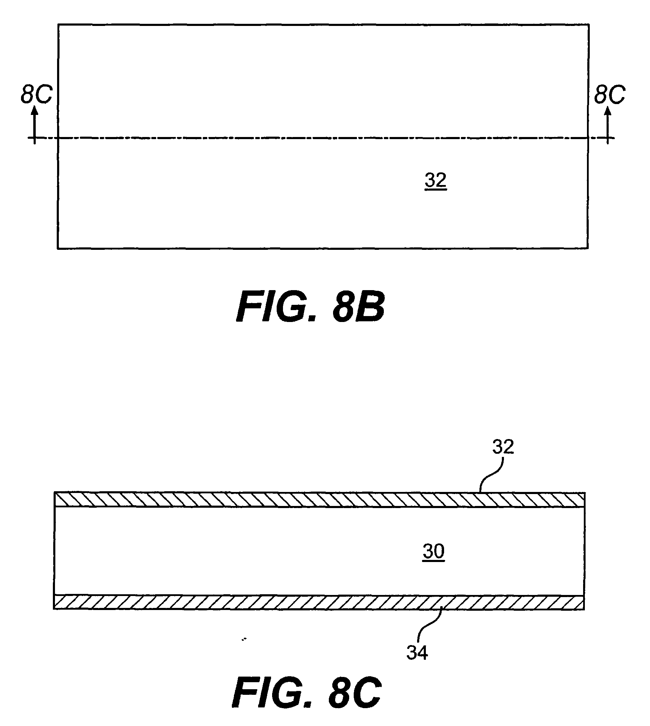

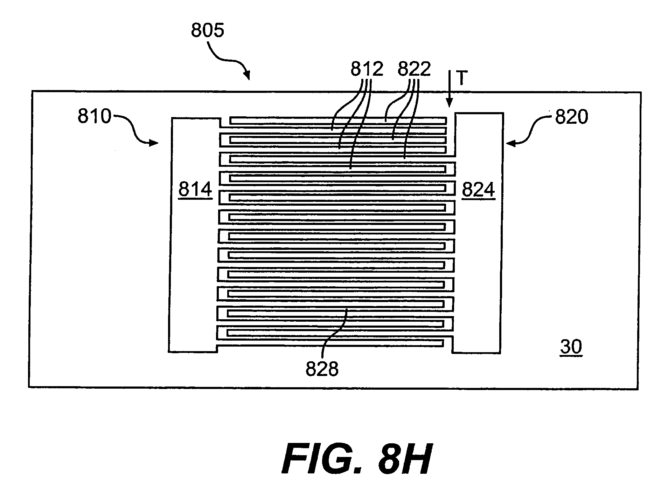

Referring to FIG. 8A, a first electrode 810 includes a plurality of first elongated electrode portions 812, connected to a first conductive portion 814. The second electrode 820 includes a plurality of second elongated electrode portions 822 electrically connected to a second conductive portion 824. The conductive portions 814, 824 act as terminations for the electrodes 810, 820, respectively. The first elongated electrode portions 812 are interdigitated with the second elongated electrode portions 822. The first and second elongated electrode portions 812, 822 are separated by a space 828 having the shape of a serpentine trench. The electrode pattern in FIG. 8A may be trimmed for fine capacitance control of the capacitor 805 (the trimming process is shown in FIG. 8H). The trimming process and a method of making the capacitor 805 and the innerlayer panel 8100 are discussed below with reference to FIGS. 8B-8I.

FIG. 8B is a plan view of a first stage of manufacturing the innerlayer panel 8100. FIG. 8C is a section view in front elevation taken on line 8C-8C in FIG. 8B. Referring to FIG. 8C, a first foil 32 is provided, and is laminated to a first side of laminate material 30. The first foil 32 may be of a type generally available in the industry. For example, the foil 32 may be copper, copper-invar-copper, invar, nickel, nickel-coated copper, or other metals. The foil 32 may correspond to between about 1 oz and 2 oz copper foil. Thick copper foils are preferred because they form thick electrodes, and provide correspondingly high capacitance densities. The laminate material 30 may be, for example, FR4 prepreg or other organic materials. A second foil 34 may also be laminated to a second side of the laminate material 30.

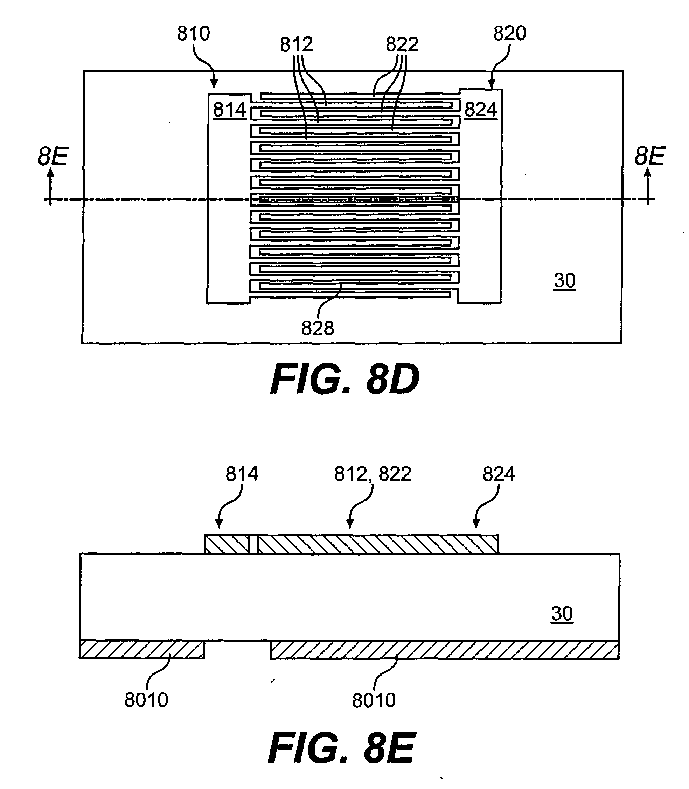

FIG. 8D is a top plan view of a next stage of manufacture. FIG. 8E is a section view taken on line 8E-8E in FIG. 8D. Referring to FIG. 8D, a photo-resist is applied to the first foil 32, and the foil 32 is imaged, etched and stripped. The electrodes 810, 812, including the first and second elongated electrode portions 812, 814, the serpentine trench 828, and the conductive portions 814, 824 result from the etching step. The second foil 34 may also be etched to form circuitry 8010. The circuitry 8010 illustrated in FIG. 8E can act as, for example, a power plane 8010 in the finished printed wiring board 8000 (illustrated in FIG. 8J).

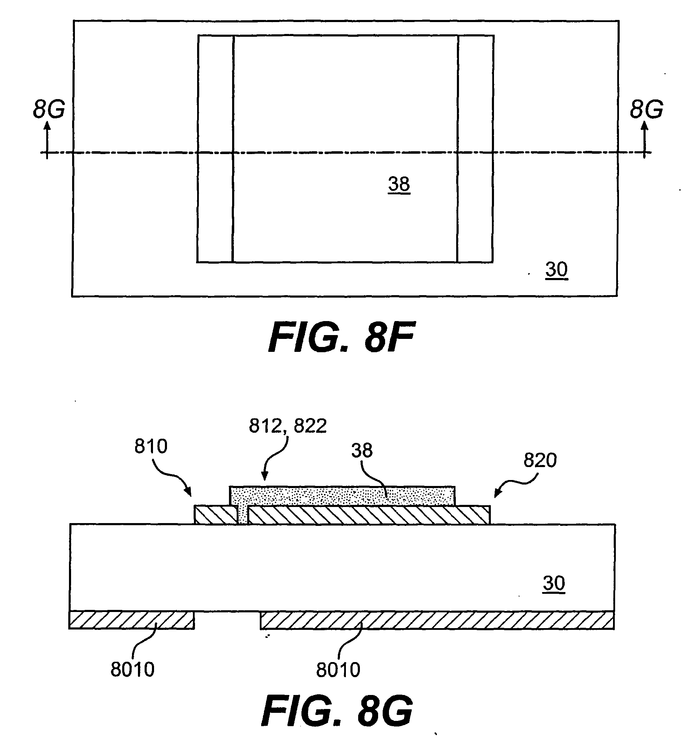

Referring to FIGS. 8F and 8G, a dielectric layer 38 is applied to the resulting article. The dielectric layer 38 is applied to fill the serpentine trench 828 between the elongated electrode portions 812, 822. The dielectric layer 38 illustrated in FIG. 8F covers the electrode portions 812 and 822. However, a dielectric layer that only fills the trench 828 between the elongated electrode portions 812, 822, without covering the tops of the electrode portions, is sufficient. Any additional surface area of the dielectric layer 38 provides a tolerance for registration issues. The dielectric layer 38 can be formed from, for example, a polymer thick film (PTF) paste. The dielectric layer 38 can be applied by, for example, solution casting or screen printing. The dielectric layer 38 is then cured.

In an interdigitated capacitor design such as is shown in FIGS. 8F and 8G, the capacitance is proportional to the depth of the electrodes 812, 822, the width of the dielectric-filled trench 828 between the electrodes 812, 822, and the length of the serpentine trench 828. The article shown FIGS. 8F and 8G has a capacitance that is above a target value. The capacitance is reduced to the target value by a trimming operation as described below.

After the dielectric is cured, the dielectric layer 38 and the elongated electrode portions 812, 822 are selectively trimmed. The trimming process is illustrated in FIG. 8H. The dielectric layer 38 is not shown in FIG. 8H to better illustrate the trimming process. The trimming direction is indicated by the arrow T. A UV-YAG laser is one preferred laser for trimming. The UV-YAG laser may selectively cut portions of either or both of the first and second elongated conductive portions 812, 822, thereby reducing the capacitance of the capacitor 805. High tolerance values can be achieved by the use of relatively short elongated conductive portions 812, 822.

Referring to FIG. 81, a dielectric 830 is illustrated as resulting from the dielectric layer 38 after the trimming operation. Laminations, etching and via formation processes, for example, may be used to form circuitry 8010, 862, 864, laminates 850, 860 and circuit conductors 8001, 8002.

FIG. 8J is a schematic section view of the printed wiring board 8000. The printed wiring board 8000 may be formed by laminating one or more innerlayer panels together, including the innerlayer panel 8100. The lamination can be performed in, for example, one or more conventional lamination pressings. In FIG. 8J, the circuit conductors 8001, 8002 correspond to the through-hole vias illustrated in FIG. 8I. The through-hole vias 8001, 8002 are preferably drilled and plated after all laminate layers have been pressed together. The circuitry 8010 may serve as a power plane. A ground plane 8012 may also be included in the printed wiring board 8000.

According to the above embodiments, high tolerances may be achieved by selective trimming of the various electrode arrangements.

In the above embodiments, the thickness of the electrode layers and the dielectric layers may vary. In general, the thickness of the layers may fall in the range of about 10-50 microns.

In the above embodiments, other types of circuit conductors may be used in place of or in addition to through-hole vias. For example, conductive connections to peripheral edges of electrode layers may be used in place of through-hole vias.

In the lamination processes described above, laminations can be performed, for example, using FR4 prepreg in standard printing wiring board processes. Type 106 epoxy prepreg may also be used. Suitable lamination conditions are, for example, 185°C at 208 psig for 1 hour in a vacuum chamber evacuated to about 28 inches of mercury. A silicone rubber press pad and a smooth PTFE-filled glass release sheet may be in contact with foils to prevent epoxy from gluing lamination plates together. The dielectric prepreg and laminate materials can be any type of dielectric material such as, for example, standard epoxy, high Tg epoxy, polyimide, polytetrafluoroethylene, cyanate ester resins, filled resin systems, BT epoxy, and other organic resins and laminates that provide insulation between circuit layers.

A single capacitor is formed in the innerlayer panels described above. However, the printed wiring board embodiments can include a large number of individual capacitors of differing type and arranged in various ways in the printed wiring boards.

The printed wiring board embodiments discussed above may include additional innerlayer panels, laminate layers, and other layers. Additional interconnect circuitry, other passive components, or active components, may also be included in the printed wiring boards.

The printed wiring board embodiments discussed above may be formed by fired-on-foil processes or by using polymeric materials. In polymeric embodiments, Curing can be done at, for example, about 150°C.

Suitable materials for the paste used to form polymeric conductive layers include, for example, polymer thick-film copper pastes, silver polymer thick-film pastes, which may include copper or silver powders dispersed into an organic vehicle. The organic vehicle can be an epoxy solution or other solutions based on other resins. A commercially available polymer conductive layer is CB200 available from E. I. du Pont de Nemours and Company.

Suitable materials for the paste used to form polymer dielectric layers include polymer thick-film dielectric pastes. Polymer thick-film dielectric pastes are generally high dielectric constant materials, such as, for example, barium titanate powder, dispersed into an organic vehicle such as an epoxy resin. A commercially available high dielectric constant polymeric dielectric layer is 7153 thick-film dielectric available from E. I. Du Pont de Nemours and Company. Curing of the conductive and dielectric layers can be performed at, for example, about 150°C.

The conductive layers discussed in this specification may also be formed by, for example, electrodeposition processes or evaporation processes. Electrodeposition processes or evaporation processes can be used to form, for example, metallic conductive layers. The dielectric layers may alternatively be formed by, for example, thin film sputtering or anodizing.

One suitable thick-film dielectric material for use in fired-on-foil embodiments has the following composition:

| | |
|---|---|
| Barium titanate powder | 64.18 % |
| Zirconium oxide powder | 3.78 % |
| Glass A | 11.63 % |
| Ethyl cellulose | 0.86 % |

| | |
|---|---|
| TEXANOL | 18.21 % |
| Barium nitrate powder | 0.84 % |
| Phosphate wetting agent | 0.5 %. |

| Glass A: | |
|---|---|
| Germanium oxide | 21.5 % |
| Lead tetraoxide | 78.5 %. |

A suitable Glass A composition corresponded to Pb₅Ge₃O₁₁, which precipitates out during the firing, and has a dielectric constant of approximately 70-150. A resulting dielectric after firing has a dielectric constant of approximately 1000.

A suitable thick-film copper electrode ink for use in fired-on-foil embodiments has the following composition:

| | |
|---|---|
| Copper powder | 55.1 % |
| Glass A | 1.6 % |
| Cuprous oxide powder | 5.6 % |
| Ethyl cellulose T-200 | 1.7 % |
| TEXANOL | 36.0 %. |

Thin film ceramic capacitors can be formed via a number of processes that yield thin ceramic layers of less than, for example, 1 micron. Examples of such materials include barium titanate or alumina, which can be deposited by sol-gel techniques or sputtering, for example.

In the fired-on-foil embodiments discussed in this specification, the term "paste" may correspond to a conventional term used in the electronic materials industry, and generally refers to a thick-film composition. Typically, the metal component of the underprint paste is matched to the metal in the metal foil. For example, if a copper foil were used, then a copper paste could be used as the underprint. Examples of other applications would be pairing silver and nickel foils with a similar metal underprint paste. Thick-film pastes may be used to form both the underprint and the passive components.

Generally, thick-film pastes comprise finely divided particles of ceramic, glass, metal or other solids dispersed in polymers dissolved in a mixture of plasticizer, dispersing agent and organic solvent. Preferred capacitor pastes for use on copper foil have an organic vehicle with good burnout in a nitrogen atmosphere. Such vehicles generally contain very small amounts of resin, such as high molecular weight ethyl cellulose, where only small amounts are necessary to generate a viscosity suitable for screen-printing. Additionally, an oxidizing component such as barium nitrate powder, blended into the dielectric powder mixture, helps the organic component burn out in the nitrogen atmosphere. Solids are mixed with an essentially inert liquid medium (the "vehicle"), then dispersed on a three-roll mill to form a paste-like composition suitable for screen-printing. Any essentially inert liquid may be used as the vehicle. For example, various organic liquids, with or without thickening and/or stabilizing agents and/or other common additives, may be used as the vehicle.

High K thick-film dielectric pastes generally contain at least one high K functional phase powder and at least one glass powder dispersed in a vehicle system composed of at least one resin and a solvent. The vehicle system is designed to be screen-printed to provide a dense and spatially well-defined film. The high K functional phase powders can comprise perovskite-type ferroelectric compositions with the general formula ABO₃. Examples of such compositions include BaTiO₃; SrTiO₃; PbTiO₃; CaTiO₃; PbZrO₃; BaZrO₃ and SrZrO_{3.} Other compositions are also possible by substitution of alternative elements into the A and/or B position, such as Pb(Mg_{1/3} Nb_{2/3})O₃ and Pb(Zn_{1/3} Nb_{2/3})O₃. TiO₂ and SrBi₂Ta₂O₉ are other possible high K materials.

Doped and mixed metal versions of the above compositions are also suitable. Doping and mixing is done primarily to achieve the necessary end-use property specifications such as, for example, the necessary temperature coefficient of capacitance (TCC) in order for the material to meet industry definitions, such as "X7R" or "Z5U" standards.

The glasses in the pastes can be, for example, Ca-Al borosilicates, Pb-Ba borosilicates, Mg-Al silicates, rare earth borates, and other similar glass compositions. High K glass-ceramic powders, such as lead germanate ( Pb₅Ge₃O₁₁) compositions, are preferred.

Pastes used to form conductive layers may be based on metallic powders of either copper, nickel, silver, silver-containing precious metal compositions, or mixtures of these compounds. Copper powder compositions are preferred.

The embodiments described in this specification have many applications. For example, one or more of the capacitor embodiments can be used within organic printed circuit boards, IC packages, applications of said structures in decoupling applications, and devices such as IC modules and devices or handheld device motherboards.

The foregoing description illustrates and describes the preferred embodiments of the present invention. It is to be understood that the invention is capable of use in various other combinations, modifications, and environments and is capable of changes or modifications within the scope of the inventive concept as expressed herein, commensurate with the above teachings, and/or the skill or knowledge of the relevant art.

The embodiments described hereinabove are further intended to explain best modes known of practicing the invention and to enable others skilled in the art to utilize the invention in such, or other, embodiments and with the various modifications required by the particular applications or uses of the invention. Accordingly, the detailed description is not intended to limit the invention to the form disclosed herein. Also, it is intended that the appended claims be construed to include alternative embodiments.

## Claims

1. A method of making a printed wiring board, comprising:
forming a first innerlayer panel, wherein forming the first innerlayer panel comprises:
forming a first electrode layer comprising a plurality of electrode portions;
forming a dielectric contacting the first electrode layer;
forming a second electrode layer spaced from the first electrode layer, wherein the first electrode layer, the dielectric and the second electrode layer form a first capacitor;
connecting the first capacitor to an organic dielectric material; and
trimming at least a part of at least one of the electrode portions; and
connecting the first innerlayer panel to at least one additional innerlayer panel.

2. The method of claim 1, wherein trimming comprises:
trimming one or more electrode portions with a laser.

3. The method of claim 2, wherein:
the laser strikes a trimmed electrode portion with a laser beam at a point that does not overlie a portion of the second electrode layer.

4. The method of any one of claims 2 or 3 wherein the laser is programmed with an electrode design and utilizes a feedback process in which the laser initially measures total capacitance and calculates the number of electrode portions that are required to be trimmed.

5. The method of claim 4 wherein the laser measures the capacitance throughout trimming.

6. The method of claim 5 wherein the laser is programmed to stop trimming within a specified range of the desired capacitance value.

7. The method of any one of claims 1-6, wherein connecting the first capacitor to an organic dielectric material comprises:
substantially encasing the first capacitor within organic dielectric material.

8. The method of any one of claims 1-7, wherein forming the first electrode layer comprises:
forming a main electrode portion of larger size than the plurality of electrode portions.

9. The method of any one of claims 1-8, wherein forming the second electrode layer comprises:
forming a plurality of second electrode portions, wherein the second electrode portions are interdigitated with the electrode portions of the first layer.

10. The method of any one of claims 1-9, wherein the thickness of the electrode layers is in the range of 10-50 microns.

11. The method of any one of claims 1-10, wherein forming the second electrode layer comprises:
providing a metallic foil; and
etching the foil.

12. The method of any one of claims 1-11, wherein connecting the first innerlayer panel to at least one additional innerlayer panel comprises:
laminating the first innerlayer panel to an additional innerlayer panel.

13. A capacitor, comprising:
a first electrode comprising a first plurality of electrode portions;
a second electrode comprising a second plurality of electrode portions spaced from the first plurality of electrode portions; and
a dielectric contacting the first electrode portions.

14. The capacitor of claim 13, further comprising:
a dielectric material that contacts and substantially encases the capacitor.

15. The capacitor of any one of claims 13 or 14 wherein one or more of the first plurality of electrode portions are trimmed to achieve a target capacitance value.

16. A capacitor, comprising:
a first electrode comprising a first plurality of electrode portions;
a second electrode comprising a second plurality of electrode portions spaced from and interdigitated with the first plurality of electrode portions; and
a dielectric disposed between the first and second pluralities of electrode portions.

17. The capacitor of claim 16, further comprising:
a dielectric material that contacts and substantially encases the capacitor.

18. The capacitor of any one of claims 16 or 17 wherein one or more of the first plurality of electrode portions are trimmed to achieve a target capacitance value.

19. The capacitor of any one of claims 13-18, wherein:
the first plurality of electrode portions comprises at least four electrode portions.

20. A printed wiring board formed by the method of any one of claims 1-12.

21. A printed wiring board containing the capacitor of any one of claims 13-18.
